# EUROPEAN PATENT APPLICATION

(11) **EP 3 090 990 A1**
(43) Date of publication of application: **09.11.2016**
(21) Application number: 15382228.3
(22) Date of filing: 04.05.2015
(51) Int. Cl.: C03C 17/25

(54) **COATED GLASS FOR SOLAR REFLECTORS**

(71) Applicant: Rioglass Solar, S.A., 33695 Pola de Lena, Lena (ES); Fundacion Tekniker, 20600 Eibar (Guipuzkoa) (ES)
(72) Inventor: UBACH CARTATEGUI, Josep, E-33612 Santa Cruz de Mieres - Asturias (ES); GOMEZ HERRERO, Estíbaliz, E-20600 Eibar, Guipúzcoa (ES); ZARRABE SARASUA, Haizea, E-20600 Eibar, Guipúzcoa (ES); ARANZABE BASTERRECHEA, Estíbaliz, E-20600 Eibar, Guipúzcoa (ES)
(74) Representative: ABG Patentes, S.L.

(57) **Abstract**

The present invention relates to a heat treated coated glass for a solar reflector comprising:
- a glass substrate, and
- an anti-soiling coating of TiO₂ over one side of the glass substrate, said coating being prepared by means of a sol-gel process which involves a thermal treatment taking place under the same process conditions for heat treatment of the glass.

## Description

### TECHNICAL FIELD OF THE INVENTION

The present invention relates to a glass comprising an anti-soiling coating and to a method of manufacturing the same.

The glass can be applied in the field of solar concentration technology for producing electric power from solar radiation.

### BACKGROUND OF THE INVENTION

Sunlight is seen as one of the most promising among renewable energy resources, since it is clean, reliable, environment respectful, endless and free. Electricity can be generated from the sun in several ways. For large-scale generation, concentrating solar thermal power (usually abbreviated as ST or CSP) plants are the most common. These systems comprise solar collectors which usually include one or more mirrors that reflect incident sunlight and focus the light at a common location or receiver, through which a working fluid (e.g., water, oil, and/or steam) flows, which is heated before transferring its heat to a boiler or power generation system. Solar collectors are widely known in the art and there are four main CSP plant variants, namely: Parabolic Trough, Fresnel Reflector, Solar Tower and Solar Dish, which differ depending on the design, configuration of mirrors and receivers, heat transfer fluid used and whether or not heat storage is involved. Another alternative for large scale electricity production using mirrors as sunrays concentrator is the Concentrated Photovoltaics (CPV). This photovoltaic technology uses the mirrors to concentrate the sunlight onto high efficiency photovoltaic solar cells, allowing a cost reduction by decreasing the photovoltaic material surface.

A solar reflector for a solar collector typically includes a mirror coating on a glass substrate. In a second surface mirror (SSM), which is the most extended configuration and the one for which the present invention is primarily intended, the mirror coating is on the rear side of the glass substrate, so that the glass substrate is located between the mirror coating and the sun. Thus, radiation from the sun proceeds first through the glass substrate, and is then reflected by the mirror coating back through the glass substrates and toward the common location such as CSP receiver or a photovoltaic cell.

However, solar reflectors are subjected to constant outdoor exposure and soiling (including dust and/or dirt) deposition severely affects the performance of the installation. Soiling generally reduces light transmittance, increases absorbance, and/or increases light-scattering. Thus, such soiling tends to lead to output power droppings of the solar collector, as it reduces the amount of radiation that can be reflected toward the common location. In environments such as hot and dry desert type terrain this is particularly problematic since they may experience periods of very low relative humidity and dust or environmental pollution can firmly stick to outside surface via condensation when temperature changes and/or due to attraction by static charge.

Manual cleaning with water and detergents involves a high cost. Therefore, many attempts have been made to provide solar reflectors with coatings or treatments that will prevent or reduce soiling. Anti-soiling coatings based on silica (SiO₂) over the glass substrates have been normally proposed to this end, mainly in nanoparticulate form, due to the hardness and durability that they confer to the coating. However, said nanoparticles must be dispersed, what usually requires the incorporation of ultrasonic or high power mechanical agitation, being difficult to assure homogeneity. Moreover, the particle size and/or the agglomeration into larger and non-spherical shapes result in crack initiation of the coating during the curing step.

It should be mentioned that TiO₂ nanoparticles with radius higher than 20 nm result in a pronounced light scattering. Light scattering can be neglected for nanoparticles with radii much smaller than the wavelength, i.e., for r«λ, but becomes of increasing importance as the size is increased. This is of large practical significance, and it is frequently of interest to avoid visible haze by ensuring that the nanoparticles in a coating are small enough, particularly for applications on transparent substrates. In these applications, haze is more pronounced at short wavelengths in the visible spectrum and the ratio of scattered to incident light should be below 0.01-0.02 in order not to affect the visible appearance of the coated glass

For instance, WO 2014/008383 discloses anti-soiling compositions for optical surfaces such as those included in solar energy generating devices. Said anti-soiling compositions are based on non-oxidizing particles and are typically applied by submerging the piece of glass into the coating liquid and then the samples are allowed to air dry under ambient conditions. Silica nanoparticles were found to efficiently prevent dust accumulation whereas titanium oxide nanoparticles, which were used as comparative example, did not provide acceptable results.

However, there still exists a need in the art for more efficient reflectors for use in solar collectors which avoid or minimize subsequent soiling.

### BRIEF DESCRIPTION OF THE INVENTION

The afore mentioned drawbacks are solved by means of a heat treated coated glass according to claim 1, a solar reflector according to claim 11, a solar installation according to claim 12, a method of manufacturing according to claim 13 and a use according to claim 15. The dependent claims present advantageous embodiments of the invention.

Thus, in a first aspect the present invention is directed to a heat treated coated glass for a solar reflector comprising:
- a glass substrate, and
- an anti-soiling coating of TiO₂ over one side of the glass substrate,
said coating being prepared by means of a sol-gel process which involves a thermal treatment taking place at the same process conditions for heat treatment of the glass.

As the skilled person knows, heat treatment of glass involves heating the glass to a temperature near its softening point and forcing it to rapidly cool under carefully controlled conditions. Heat-treated glasses can be classified as either fully tempered or heat strengthened, according to their surface compression degrees. The heat-treating process produces highly desirable conditions of induced stress which result in additional strength -achieving up to six times that of the normal annealed glass-, resistance to thermal stress and impact resistance. These improved conditions are especially advantageous for solar reflectors located in the open air, usually in desert regions, where the collector is subjected to huge temperature variations and high wind loads in those large open spaces.

The heat-treating process for either, tempering or heat-strengthening glass, confers enhanced resistance properties to the glass of the invention. During said process, once the piece of heat-treated glass pane has been softened, it may be bent in a continuous process to a curved shape suitable for a solar collector. The glass is preferably bent in a substantially parabolic shape but other shapes - such as cylindrical or spherical - can be envisaged for different embodiments of the invention.

The heat treatment of the glass according to the present invention may be performed in the same processing equipment and under the same conditions as those used in the state of the art for conferring enhanced resistance properties to glasses. Ordinary annealed glass, without special treatment, is widely used in the technical field of the invention. However, this glass can become fragile when exposed to wind loads, impact of solids in the open air and when be provided with bores it cannot bear the necessary mounting or fixing stresses.

The thermal coating process according to the present invention takes place simultaneously with the heat treatment of the glass without defects or cracking problems. Unlike prior-art coatings aimed at reducing the dust accumulation over the reflectors of solar installations, which are mainly based on nanoparticles of SiO₂, the present inventors have developed a TiO₂-based coating with avoids the use of nanoparticles dispersion processes, unreliable in terms of homogeneity and obtaining smooth glassy surfaces. Advantageously, this anti-soiling coating is initially applied as a sol in liquid form over the glass, i.e. before any subsequent process necessary to create the properties desired for the glass, and once deposited, a conventional heat treatment (i.e. bending and strengthening/tempering) of the glass allows the formation of a chemical covalent bond between the TiO₂ and the glass resulting in a durable and homogeneous dense coating which shows excellent anti-soiling properties due to the hydrophilic behavior of the TiO₂ once in contact with water.

Other important feature of the invention is that TiO₂ has photocatalytic properties, and therefore provides a multifunctional coating. TiO₂ is regarded as the most efficient and environmentally benign photocatalyst, and it has been most widely used for photodegradation of various pollutants. Upon absorption of photons with energy larger than the band gap of TiO₂, electrons are excited from the valence band to the conduction band, creating electron-hole pairs. These charge carriers migrate to the surface and react with the chemicals adsorbed on the surface to decompose these chemicals. This photodecomposition process usually involves one or more radicals or intermediate species such as •OH, O²⁻, H₂O₂, or O₂, which play important roles in the photocatalytic reaction mechanisms. In the same way, the higher the crystallinity, the fewer the bulk defects, and the higher the photocatalytic activity is.

Moreover, despite the fact that TiO₂ is not completely transparent and as a result of a controlled thickness of the coating, the effect of the coating deposition on the reflective optical properties it is irrelevant for its functional purposes. The coated glass of invention does not only prevent and reduce soiling accumulation, but the coated areas have become easier to clean than the non-coated surfaces after long periods of outdoor exposure, surprisingly revealing an increased measured reflectance after only 15 months of outdoor exposure.

In another aspect, the present invention is directed to a solar reflector comprising the heat treated coated glass described herein. A particular solar reflector according to the present invention comprises:
- a glass substrate,
- an anti-soiling coating of TiO₂ prepared by means of a sol-gel process which involves a thermal treatment taking place under the same process conditions for heat treatment of the glass. and
- a mirror coating,
wherein the anti-soiling coating and the mirror coating are located on opposite sides of the glass substrate.

The mirror coating comprises at least a reflective layer or coating. In certain embodiments of the present invention, the mirror coating comprises at least a reflective layer and at least a protective layer thereof located on the rear side of the mirror. In a particular embodiment, the mirror coating comprises a first reflective layer comprising a metal (such as silver), an antioxidant or passivation layer comprising a metal (such as copper) and at least a protective layer of paint. In a more particular embodiment, the mirror coating comprises a first reflective layer made of silver, an antioxidant or passivation layer made of chemically deposited copper and three protective layers of paint.

In another aspect, the present invention is directed to a solar installation comprising the solar reflector described herein.

A further aspect of the invention is the method of manufacturing the heat treated coated glass for a solar reflector described herein, said method comprising:
- applying over one side of a glass substrate a sol-gel solution in liquid form obtained from the hydrolysis and condensation reactions between a precursor of TiO₂ and water, and
- subjecting the glass thus coated to a heat-treating process by which the coating densifies and forms a solid anti-soiling coating of TiO₂ over one side of the glass substrate.

The method for producing the heat treated coated glass of the invention is cheap, simple and reproducible since it is based on conventional sol-gel processing which allows an important energy saving as it makes advantageously use of the glass curing process for densifying the coating.

A further aspect of the invention is directed to the heat treated coated glass for a solar reflector obtainable by the above-mentioned method of manufacturing.

A further aspect of the invention relates to the use of the heat treated coated glass described herein in solar concentration technology, particularly as an element of solar reflectors.

Heat treated coated glasses according to certain embodiments of this invention may be used in applications such as one or more of: parabolic-trough power plants, compound parabolic concentrating collectors, solar dish-engine systems, solar thermal power plants, and/or solar collectors, which rely on mirror(s) to reflect and direct solar radiation from the sun.

These and other aspects of the invention will be apparent from and elucidated with reference to the embodiments described hereinafter.

### BRIEF DESCRIPTION OF THE DRAWINGS

To better understand the invention, its objects and advantages, the following figures are attached to the specification in which the following is depicted:

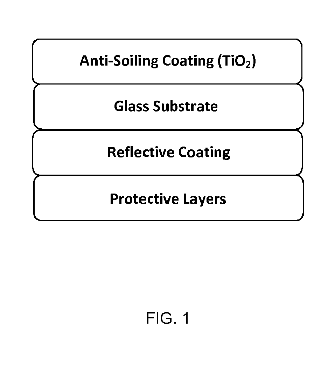

Figure 1 is a schematic diagram of a solar reflector according to an embodiment of the present invention. In particular, the reflector is made of a glass having an anti-soiling coating of TiO₂ and a reflective coating (e.g. Ag) and its protective layers located on the opposite (rear) side from the anti-soiling TiO₂ coating.

### DETAIL DESCRIPTION OF THE INVENTION

It is an object of the present invention to provide a heat treated coated glass useful for solar reflectors. Such a glass comprises:
- a glass substrate, and
- an anti-soiling coating of TiO₂ over one side of the glass substrate,
said coating being prepared by means of a sol-gel process which involves a thermal treatment taking place under the same process conditions for heat treatment of the glass.

The sol-gel process is a widely known method for producing solid materials from small molecules, which involves conversion of monomers into a colloidal solution (sol) that acts as the precursor for an integrated network (or gel) of either discrete particles or network polymers. In a typical sol-gel process, a colloidal suspension, or a sol, is formed from the hydrolysis and condensation reactions of the precursors, which are usually inorganic metal salts or metal organic compounds such as metal alkoxides. Complete polymerization and loss of solvent leads to the transition from the liquid sol into a solid gel phase.

A suitable sol-gel solution to be used in the present invention to form the TiO₂-based anti-soiling coating comprises:
- at least one inorganic precursor agent (i.e. TiO₂-precursor) of formula

   Ti(X)₄ (I)

   wherein the X groups, being the same or different, are hydrolyzable groups preferably selected from -O-R alkoxy, -O-C(O)R acyloxy and halogens; or a hydrolyzate of this precursor agent;
- at least one organic solvent;
- water; and
- optionally a hydrolysis and condensation catalyst.

As used herein, sol-gel solution refers to the mixture of substances which has to be combined to produce the initial colloidal solution (sol) and the subsequent integrated network (gel) which finally results in a dense coating based on TiO₂.

Compound (I) is the precursor for TiO₂-based matrix. In certain embodiments, X is selected from -O-R alkoxy and -O-C(O)R acyloxy groups, wherein R is an alkyl radical, preferably a C₁-C₆ alkyl radical. In other embodiments, X is an halogen such as Cl, Br or I.

Preferably, the X groups are alkoxy groups, and in particular methoxy, ethoxy, propoxy (such as iso-propoxy) and butoxy (such as n-butoxy) groups.

Preferred compounds of formula (I) are tetraalkyl titanates. Amongst them, titanium isopropoxide (also commonly referred to as tetraisopropyl titanate, titanium tetraisopropoxide or TTIP) or titanium n-butoxide (also commonly referred to as tetrabutyl titanate or TNBT) will be advantageously used. More preferably, the precursor agent of formula (I) is tetrabutyl titanate (TNBT).

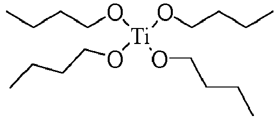

As used herein, the term "about" means a slight variation of the value specified, preferably within 10 percent of the value specified. Nevertheless, the term "about" can mean a higher tolerance of variation depending on for instance the experimental technique used. Said variations of a specified value are understood by the skilled person and are within the context of the present invention. Further, to provide a more concise description, some of the quantitative expressions given herein are not qualified with the term "about". It is understood that, whether the term "about" is used explicitly or not, every quantity given herein is meant to refer to the actual given value, and it is also meant to refer to the approximation to such given value that would reasonably be inferred based on the ordinary skill in the art, including equivalents and approximations due to the experimental and/or measurement conditions for such given value.

Inorganic precursor agents of formula (I) that are present in the sol generally account for about 5 to about 40% by weight of the total weight (including all other compounds that are present in the sol-gel solution, in particular the solvent) of the sol-gel solution. In particular embodiments, the weight percentage of the inorganic precursor ranges from about 10 to about 35 wt% or from about 12 to about 30 wt%.

Organic solvents or mixtures of organic solvents to be suitably used for preparing the sol-gel solution according to the invention are all classically employed solvents, and more particularly polar solvents, especially alkanols such as methanol, ethanol, isopropanol, isobutanol, n-butanol and mixtures thereof. Other solvents, preferably water-soluble solvents, may be used, such as 1,4-dioxane, tetrahydrofurane or acetonitrile. Ethanol is the most preferred organic solvent.

Generally, the organic solvent represents from about 40 to about 90% by weight of the sol-gel solution total weight (e.g. from about 50 to about 90 wt%, from about 60 to about 90 wt%, etc.). Water represents typically from about 0.5 to 10% by weight of the sol-gel solution total weight (e.g. from about 1 to about 9 wt%, from about 1 to about 6 wt%, etc.).

The medium in which the precursor agent of formula (I) is present is typically an acidic medium, the acidic character of the medium being obtained through addition, for example, of an inorganic acid, typically HCl, HNO₃ or H₂SO₄ or of an organic acid such as acetic acid. This acid acts as a hydrolysis and condensation catalyst by catalyzing the hydrolysis of the X groups of the compound of formula (I). A particularly preferred hydrolysis and condensation catalyst is HCl. Nevertheless, base catalysts are also contemplated in the present invention for catalyzing the hydrolysis and condensation of the inorganic precursor agent.

According to preferred embodiments, the sol-gel solution comprises TNBT as inorganic precursor agent of formula (I), ethanol as organic solvent, water and HCl as catalyst. Typical molar ratios of these components are the following: TNBT/Ethanol/Water= 0.5-1.5 : 20-60 : 1-4. HCl may be normally added until acid pH such as pH = 2.

In a particular preferred embodiment, the sol-gel solution has the following composition TNBT/Ethanol/Water = 1 : 20 : 4.

The above molar ratios are also contemplated for other sol-gel solutions i.e. with a different precursor agent of formula (I) and/or a different organic solvent.

The person skilled in the art will recognize that there are a number of technologies in the art suitable for applying the sol over the glass. These include, without limitation, dip-coating, spray-coating, flow-coating, roll-coating, and the like. Dip-coating and spray-coating are preferred coating processes.

In a dip-coating process, the glass substrate is covered/protected on one side and immersed in the sol, preferably at a constant speed. The substrate remains inside the sol for a while and is starting to be pulled up. Deposition of the coating layer on the substrate takes place while it is pulled up and the withdrawing is carried out preferably at a constant speed. The speed determines the thickness of the coating (faster withdrawal gives thicker coating material) and therefore its optical properties. According to a preferred embodiment, the withdrawing speed ranges from about 150 to about 250 mm/min, such as about 175 to about 225 mm/min, preferably about 200 mm/min.

Once the coating is deposited on the glass substrate, the glass is subjected to a heat-treatment processing (curing). In a conventional heat-treatment processing, the glass is properly positioned on the loading table of the heating oven and progressively heated to its bending temperature by continuous, or step-by-step, travelling through the heating tunnel. Radiation with electrical heat sources or convection by means of hot air heating can be used to heat up the glass. As the glass reaches the desired temperature, it is rapidly moved to the bending section, where the glass is bended to its desired curved shape and immediately heat strengthened or tempered (heat treatment) with rapid cooling by means of violent air blowing on both glass sides. After this heat treatment the glass is cooled down to a normal handling temperature (under 50°C) by continuous travelling in a cooling tunnel where it is blown with atmospheric air coming from one or several fans.

When thermally heat strengthened, the glass has compressive layers in both surfaces between 20 Mpa and 69 Mpa, resulting in improved mechanical properties with respect to typical annealed glass reflectors in use.

When thermally tempered, the glass has compressive layers in both surfaces in excess of 70 Mpa, resulting in improved mechanical properties with respect to typical annealed glass reflectors in use.

Advantageously, under the heat-treatment, the residual solvent and traces of organic compounds are driven off of the coating and TiO₂ is covalently immobilized by Ti-O-Ti bonds on the glass so that the coating densifies and forms a durable coating with excellent anti-soiling properties.

All these operations, including bending and heat treatment, may be carried out in equipments which are conventional in the glass industry such those used in the manufacturing of heat-treated glass, well known to the skilled person, like for example in the automobile industry.

Furnace parameters (glass speed, temperatures, bender operation, air pressure, etc), furnace operations and their coordination are preferably fully automatic and controlled by means of a sophisticated computer control system.

The bent glass is then moved to a coating line to provide it with the necessary reflective capabilities and conducting a mirroring process.

According to the above procedure, anti-soiling coatings of TiO₂ of very different thicknesses may be easily obtained in a cost-efficient manner. In certain embodiments, the anti-soiling coating of TiO₂ ranges from about 50 nm to 1 about micron thick. In preferred embodiments, it is about 50-250 nm thick, more preferably about 100-200 nm thick and even more preferably about 150 nm thick.

Glass substrate may be from about 1-10 mm thick in different embodiments of this invention, and maybe any suitable color (e.g., grey, clear, green, blue, etc.). In certain example instances, glass (e.g., soda lime silica type glass) substrate is from about 3-10 mm thick, most preferably about 3-6 mm thick.

The mirror coating may be of or include Al, Ag or any other suitable reflective material in certain embodiments of this invention.

Additionally, solar reflectors according to the invention may be provided with protective layers or coatings of the reflective coating on the rear side of the mirror. In a particular embodiment, the mirror coating of the reflector comprises a reflective coating (such as silver), a first protective layer comprising a metal (such as copper) and a second protective layer thereof of paint. In another particular embodiment, the mirror coating comprises a reflective coating comprising silver, a first protective layer comprising copper and three protective layers of paint.

In certain instances, the solar reflectors may be mounted on a steel or other metal based support system.

All the features described in this specification (including the claims, description and drawings) and/or all the steps of the described method can be combined in any combination, with the exception of combinations of such mutually exclusive features and/or steps.

The invention will be further illustrated by means of examples, which should not be interpreted as limiting the scope of the claims.

### EXAMPLES

### Example 1 - Preparation of heat treated coated glass

A sol-gel solution was carried out mixing in a reactor 620 g of titanium n-butoxide as titanium precursor and 1520 g of ethanol as solvent. Then 65 g of water acidified with hydrochloric acid (catalyst of the reaction) until acid pH (pH = 2) were added under vigorous stirring. The solution was then stirred during 24 hours at room temperature.

Glass samples of 270 x 440 mm were cleaned with a cleaning agent, washed with distilled water and then dried in air. One of the sides of the sample was covered in order to deposit the coating only on the other side. This glass was dipped into the above-mentioned solution and withdrawn at a speed of 200 mm/min. After drying during 30 minutes at room temperature, the coated glass samples were thermally cured following a typical heat strength process for tempering glasses.

### Example 2 - Reflectance study of solar reflector

The inventors have studied the reflectance of a solar reflector partially coated with the TiO₂ coating of the present invention on 2/3 of its surface. Several samples of 270 x 440 mm were tested in outdoor conditions in the same environment of a CSP real plant. After 3 months in outdoor exposure with a cleaning frequency every two weeks, the reflectance measured before cleaning in the coated area was as average 2 ppt higher than in the uncoated one. These results are shown in Table 1.

**Table 1**

| **Sample** | **Average Δρ _{coated-uncated} (ppt)** |
|---|---|
| Sample A | 2 |
| Sample B | 2.2 |
| Sample C | 2.1 |
| Sample D | 2 |

Further, visually, the dust accumulation over the uncoated glass was clearly superior.

Among the advantageous properties of the coating, the inventors, have found out that surprisingly, after 15 months in outdoor exposure, the reflectance of the coated area has increased 0.2 ppt as average with regards to the initial values of the experiment, meanwhile, the reflectance of the uncoated area remains the same. These results are shown in Table 2.

**Table 2**

| **Sample** | **Average Δρ _{final coated- initial coated} (ppt)** | **Average Δρ _{final uncoated- initial uncoated} (ppt)** |
|---|---|---|
| Sample E | 0.1 | 0.0 |
| Sample F | 0.3 | 0.2 |
| Sample G | 0.1 | -0.2 |
| Sample H | 0.2 | 0.1 |
| Sample I | 0.2 | -0.2 |

These studies prove that the TiO₂ coating of the present invention has excellent anti-soiling properties.

## Claims

1. A heat treated coated glass for a solar reflector comprising:
- a glass substrate, and
- an anti-soiling coating of TiO₂ over one side of the glass substrate,
said coating being prepared by means of a sol-gel process which involves a thermal treatment taking place under the same process conditions for heat treating the glass.

2. The glass according to claim 1 wherein the sol-gel process uses a sol-gel solution comprising:
- at least one inorganic precursor agent of formula
Ti(X)₄ (I)
wherein the X groups, being the same or different, are hydrolyzable groups preferably selected from -O-R alkoxy, -O-C(O)R acyloxy and halogens; or a hydrolyzate of this precursor agent;
- at least one organic solvent;
- water; and
- optionally a hydrolysis and condensation catalyst.

3. The glass according to claim 2, wherein R is a C₁-C₆ alkyl radical.

4. The glass according to any one of claims 2 to 3, wherein the precursor agent of formula (I) is tetrabutyl titanate (TNBT).

5. The glass according to any one of claims 2 to 4, wherein the organic solvent is selected from an alkanol and preferably is ethanol.

6. The glass according to any one of claims 2 to 5, wherein the hydrolysis and condensation catalyst is selected from an inorganic acid and preferably is HCl.

7. The glass according to any one of claims 2 to 6, wherein the sol-gel solution comprises TNBT, ethanol, water and HCl.

8. The glass according to claim 7, wherein the sol-gel solution has the following molar ratios: TNBT/Ethanol/Water = 0.5-1.5 : 20-60 : 1-4.

9. The glass according to claim 8, wherein the sol-gel solution has the following molar ratios: TNBT/Ethanol/Water/HCl = TNBT/Ethanol/Water= 1 : 20 : 4.

10. The glass according to any one of the preceding claims, wherein the anti-soiling coating has a thickness from about 50 nm to about 1 micron, preferably about 150 nm thick.

11. A solar reflector comprising a heat treated coated glass as defined in any one of claims 1 to 10 and a mirror coating, wherein the anti-soiling coating and the mirror coating are located on opposite sides of the glass substrate.

12. A solar installation comprising the solar reflector as defined in claim 11.

13. A method of manufacturing a heat treated coated glass for a solar reflector, said method comprising:
- applying over one side of a glass substrate a sol-gel solution in liquid form obtained from the hydrolysis and condensation reactions between a precursor of TiO₂ and water, and
- subjecting the glass thus coated to a heat-treating process by which the coating densifies and forms a solid anti-soiling coating of TiO₂ over one side of the glass substrate.

14. The method according to claim 13, wherein the solution is applied over the glass substrate by dip-coating, spray-coating, flow-coating, roll-coating, or the like.

15. Use of a heat treated coated glass as defined in any one of claims 1 to 10 as an element of solar reflectors.
